# EUROPEAN PATENT APPLICATION

(11) **EP 3 614 425 A1**
(43) Date of publication of application: **26.02.2020**
(21) Application number: 18787536.4
(22) Date of filing: 06.03.2018
(51) Int. Cl.: H01L 23/29, C08F 283/01, C08K 3/00, C08K 5/098, C08K 5/5415, C08K 7/14, C08L 67/06, H01L 23/31

(54) **RESIN COMPOSITION FOR SEALING ELECTRONIC CONTROL DEVICE, ELECTRONIC CONTROL DEVICE, AND METHOD FOR MANUFACTURING SAME**

(30) Priority: 20.04.2017 JP 2017083588
(71) Applicant: Showa Denko K.K., Tokyo 105-8518 (JP)
(72) Inventor: ISHIUCHI, Ryujin, Tokyo 105-8518 (JP); NIIHARA, Takao, Tokyo 105-8518 (JP); YAMAUCHI, Shintaro, Tokyo 105-8518 (JP)
(74) Representative: Kador & Partner PartG mbB
(86) International application number: PCT/JP2018/008504
(87) International publication number: WO 2018/193735

(57) **Abstract**

A resin composition for sealing an electronic control device, which contains (A) at least one type of thermosetting resin selected from among an unsaturated polyester resin and a vinyl ester resin, (B) a polymerizable unsaturated compound, (C) an inorganic filler, (D) glass fibers, (E) an internal mold release agent, (F) a coupling agent, and (G) a curing agent, and in which, relative to a total of 100 parts by mass of the thermosetting resin (A) and the polymerizable unsaturated compound (B), the content of the inorganic filler (C) is 150 to 700 parts by mass, the content of the glass fibers (D) is 0.1 to 60 parts by mass, and the content of the coupling agent (F) is 1.4 to 20 parts by mass.

## Description

### Technical Field

This invention relates to a resin composition for sealing an electronic control device, an electronic control device and a method for producing same.

### Background Art

Electronic control devices such as electronic control units fitted to motor vehicles and the like must prevent the ingress of water, corrosive gases, and the like, in order to protect circuit boards, electronic components mounted on the circuit boards, and the like.

For example, Patent Document 1 discloses collectively sealing a gap between a QFP-type package and a circuit board with an epoxy resin composition that contains an epoxy resin, a curing agent, and an inorganic filler. In addition, Patent Document 2 discloses sealing a semiconductor device using a resin composition for sealing semiconductors, which contains a thermosetting resin, a curing agent, and a compounded metal hydroxide having a polyhedral form.

### Citation List

### Patent Document

Patent Document 1: JP 2014-148586 A
Patent Document 2: JP 2003-82243 A

### Summary of Invention

### Technical Problem

However, epoxy resins such as that used in Patent Document 1 are relatively expensive among resins in terms of raw material unit price, and therefore have the problem of being difficult to use in large articles. Furthermore, because epoxy resin compositions have high molding temperatures of 170°C to 180°C, improvements were required in terms of electronic control device reliability, productivity and cost. In addition, the resin composition for sealing semiconductors disclosed in Patent Document 2 does not exhibit adequate heat resistance, and therefore suffers from problems such as cracking due to expansion and shrinkage caused by temperature changes.

This invention has been developed in order to solve problems such as those mentioned above, and has the purpose of providing a resin composition for sealing an electronic control device, which is inexpensive and exhibits excellent moldability and heat resistance.

### Solution to Problem

As a result of diligent research into how to solve the problem mentioned above, the inventors of this invention found that by combining at least one type of thermosetting resin selected from among an unsaturated polyester resin and a vinyl ester resin, a polymerizable unsaturated compound, an inorganic filler, glass fibers, an internal mold release agent, a coupling agent, and a curing agent at specific blending proportions, it was possible to provide a resin composition for sealing an electronic control device, which is inexpensive and exhibits excellent moldability and heat resistance, and thereby completed this invention.

That is, this invention is items [1] to [10] below.
[1] A resin composition for sealing an electronic control device, the resin composition comprising:
   (A) at least one type of thermosetting resin selected from among an unsaturated polyester resin and a vinyl ester resin,
   (B) a polymerizable unsaturated compound,
   (C) an inorganic filler,
   (D) glass fibers,
   (E) an internal mold release agent,
   (F) a coupling agent, and
   (G) a curing agent,
   wherein, relative to a total of 100 parts by mass of the thermosetting resin (A) and the polymerizable unsaturated compound (B), the content of the inorganic filler (C) is 150 to 700 parts by mass, the content of the glass fibers (D) is 0.1 to 60 parts by mass, and the content of the coupling agent (F) is 1.4 to 20 parts by mass.
[2] The resin composition for sealing an electronic control device according to [1], wherein the content of the coupling agent (F) is 3.0 to 15 parts by mass relative to a total of 100 parts by mass of the thermosetting resin (A) and the polymerizable unsaturated compound (B).
[3] The resin composition for sealing an electronic control device according to [1] or [2], wherein the inorganic filler (C) is a powder and has an average primary particle diameter of 0.5 to 30 µm.
[4] The resin composition for sealing an electronic control device according to any one of [1] to [3], wherein the inorganic filler (C) is at least one type selected from among calcium carbonate, aluminum hydroxide and aluminum oxide.
[5] The resin composition for sealing an electronic control device according to any one of [1] to [4], wherein the fiber length of the glass fibers (D) is 0.01 mm to 13 mm.
[6] The resin composition for sealing an electronic control device according to any one of [1] to [5], wherein the content of the internal mold release agent (E) is 3 to 15 parts by mass relative to a total of 100 parts by mass of the thermosetting resin (A) and the polymerizable unsaturated compound (B).
[7] The resin composition for sealing an electronic control device according to any one of [1] to [6], wherein the thermosetting resin (A) is an unsaturated polyester resin.
[8] An electronic control device, wherein a space between a metal housing and a substrate is filled with a cured product of a resin composition, the resin composition comprising:
   (A) at least one type of thermosetting resin selected from among an unsaturated polyester resin and a vinyl ester resin,
   (B) a polymerizable unsaturated compound,
   (C) an inorganic filler,
   (D) glass fibers,
   (E) an internal mold release agent,
   (F) a coupling agent, and
   (G) a curing agent,
   wherein, relative to a total of 100 parts by mass of the thermosetting resin (A) and the polymerizable unsaturated compound (B), the content of the inorganic filler (C) is 150 to 700 parts by mass, the content of the glass fibers (D) is 0.1 to 60 parts by mass, and the content of the coupling agent (F) is 1.4 to 20 parts by mass.
[9] A method for producing an electronic control device, the method comprising filling a space between a metal housing and a substrate with a resin composition, and curing the resin composition, the resin composition comprising:
   (A) at least one type of thermosetting resin selected from among an unsaturated polyester resin and a vinyl ester resin,
   (B) a polymerizable unsaturated compound,
   (C) an inorganic filler,
   (D) glass fibers,
   (E) an internal mold release agent,
   (F) a coupling agent, and
   (G) a curing agent,
   wherein, relative to a total of 100 parts by mass of the thermosetting resin (A) and the polymerizable unsaturated compound (B), the content of the inorganic filler (C) is 150 to 700 parts by mass, the content of the glass fibers (D) is 0.1 to 60 parts by mass, and the content of the coupling agent (F) is 1.4 to 20 parts by mass.
[10] The method for producing an electronic control device according to [9], wherein the resin composition is filled and cured by means of transfer molding or injection molding.

### Advantageous Effects of Invention

According to this invention, it is possible to provide a resin composition for sealing an electronic control device, which is inexpensive and exhibits excellent moldability and heat resistance.

### Brief Description of Drawings

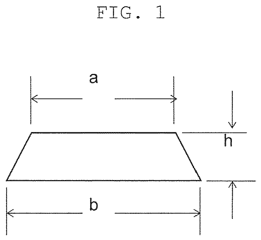

Fig. 1 is a flow path cross section of a spiral flow mold used in a spiral flow test.

### Description of Embodiments

The resin composition for sealing an electronic control device, electronic control device and method for producing same of this invention will now be explained. Moreover, in this specification, the term "(meth)acrylic acid" means at least one type selected from among methacrylic acid and acrylic acid, and the term "(meth)acrylate" means at least one type selected from among acrylate and methacrylate.

### [Resin composition for sealing electronic control device]

The resin composition for sealing an electronic control device of this invention contains (A) a thermosetting resin, (B) a polymerizable unsaturated compound, (C) an inorganic filler, (D) glass fibers, (E) an internal mold release agent, (F) a coupling agent, and (G) a curing agent as essential components.

### (A) Thermosetting resin

The thermosetting resin (A) used in this invention is at least one type selected from among an unsaturated polyester resin and a vinyl ester resin. From the perspectives of low cost and excellent mechanical strength and heat resistance of a cured product, the thermosetting resin (A) is preferably an unsaturated polyester resin. In cases where a combination of an unsaturated polyester resin and a vinyl ester resin is used, the content of the unsaturated polyester resin is preferably 30 mass% to less than 100 mass%, more preferably 40 mass% to less than 100 mass%, and most preferably 50 mass% to less than 100 mass%, relative to the mass of the thermosetting resin (A).

The unsaturated polyester resin is a polycondensate of a polyhydric alcohol and an unsaturated polybasic acid or a polycondensate of a polyhydric alcohol, an unsaturated polybasic acid and a saturated polybasic acid, and the type thereof is not particularly limited. It is possible to use one type of unsaturated polyester resin, or two or more types thereof. The unsaturated polyester resin used in this invention can be synthesized using a publicly known synthesis method.

The polyhydric alcohol used to synthesize the unsaturated polyester resin is not particularly limited, and can be a publicly known compound. Examples of polyhydric alcohols include ethylene glycol, propylene glycol, butane diol, diethylene glycol, dipropylene glycol, triethylene glycol, pentane diol, hexane diol, neopentane diol, neopentyl glycol, hydrogenated bisphenol A, bisphenol A and glycerin. It is possible to use one of these polyhydric alcohols, or two or more types thereof. Of these, use of a polyhydric alcohol selected from among neopentyl glycol and propylene glycol is preferred from the perspective of obtaining an unsaturated polyester resin which exhibits good compatibility with the polymerizable unsaturated compound (B) and gives a cured product having excellent mechanical strength and heat resistance.

The unsaturated polybasic acid used to synthesize the unsaturated polyester resin is not particularly limited, and can be a publicly known compound. Examples of unsaturated polybasic acids include maleic acid, maleic anhydride, fumaric acid, citraconic acid and itaconic acid. It is possible to use one of these unsaturated polybasic acids, or two or more types thereof. Of these, use of an unsaturated polybasic acid selected from among fumaric acid, maleic acid, itaconic acid and phthalic acid is preferred from the perspective of obtaining an unsaturated polyester resin which is inexpensive and gives a cured product having excellent mechanical strength and heat resistance.

Examples of preferred combinations of a polyhydric alcohol and an unsaturated polybasic acid include a combination of fumaric acid and neopentyl glycol, a combination of maleic acid and dipropylene glycol and a combination of fumaric acid and propylene glycol. Of these, a combination of fumaric acid and propylene glycol is preferred from the perspective of obtaining an unsaturated polyester resin which is inexpensive and gives a cured product having a high heat deformation temperature and excellent mechanical strength and heat resistance.

The saturated polybasic acid used to synthesize the unsaturated polyester resin is not particularly limited, and can be a publicly known compound. Examples of saturated polybasic acids include phthalic acid, phthalic anhydride, isophthalic acid, terephthalic acid, HET acid, succinic acid, adipic acid, sebacic acid, tetrachlorophthalic anhydride, tetrabromophthalic anhydride and endo-methylenetetrahydrophthalic anhydride. It is possible to use one of these saturated polybasic acids, or two or more types thereof.

The unsaturated polyester resin can be synthesized using a publicly known method using raw materials mentioned above. Synthesis conditions for the unsaturated polyester resin are set as appropriate according to the raw materials being used and quantities thereof. In general, esterification should be carried out at a temperature of 140°C to 230°C under increased or reduced pressure in a stream of an inert gas, such as nitrogen. If necessary, a catalyst can be used in this esterification reaction. Examples of the catalyst include publicly known catalysts such as manganese acetate, dibutyl tin oxide, stannous oxalate, zinc acetate and cobalt acetate. It is possible to use one of these catalysts, or two or more types thereof.

The weight average molecular weight (MW) of the unsaturated polyester resin is not particularly limited, but is preferably 2,000 to 50,000, more preferably 3,000 to 30,000, and most preferably 5,000 to 20,000. If the weight average molecular weight of the unsaturated polyester resin is 2,000 to 50,000, it is possible to obtain an unsaturated polyester resin that gives a cured product having excellent mechanical strength and electrical characteristics.

Moreover, in this specification, the term "weight average molecular weight" means a value measured at ordinary temperature under the conditions below using gel permeation chromatography (product name: Shodex (registered trademark) GPC-101, available from Showa Denko K.K.) and using a standard polystyrene calibration curve.
Column: LF-804 (product name), available from Showa Denko K.K.
Column temperature: 40°C
Sample: 0.2 mass% tetrahydrofuran solution of copolymer
Flow rate: 1 mL/min
Eluant: Tetrahydrofuran
Detector: RI-71S

The vinyl ester resin is an epoxy (meth)acrylate obtained by esterification of an epoxy resin and an α,β-unsaturated monocarboxylic acid using a publicly known method.

Examples of the epoxy resin used to synthesize the vinyl ester resin include diglycidyl ether compounds of bisphenol compounds such as bisphenol A, bisphenol AD and bisphenol F, high molecular weight homologs thereof, phenol novolac type poly(glycidyl ether) compounds and cresol novolac type poly(glycidyl ether) compounds. Furthermore, aliphatic epoxy resins and compounds obtained by reacting phenol compounds such as bisphenol A, bisphenol AD, bisphenol F and bisphenol S with glycidyl ethers of these may be used in the synthesis process. Of these, use of a bisphenol A type epoxy resin is preferred from the perspective of obtaining a vinyl ester resin having excellent mechanical strength and chemical resistance.

Examples of the α,β-unsaturated monocarboxylic acid used to synthesize the vinyl ester resin generally include acrylic acid and methacrylic acid. In addition, crotonic acid, tiglic acid, cinnamic acid, or the like, can be used as the α,β-unsaturated monocarboxylic acid. Of these, use of (meth)acrylic acid is preferred from the perspective of obtaining a vinyl ester resin that gives a cured product having excellent mechanical strength and chemical resistance.

The vinyl ester resin can be synthesized by esterification of a glycidyl ether of a bisphenol compound mentioned above and an α,β-unsaturated monocarboxylic acid at a carboxyl group/epoxy group ratio of 1.05 to 0.95 at a temperature of 80°C to 140°C. Furthermore, a catalyst can be used if necessary. Examples of the catalyst include tertiary amine compounds such as benzyldimethylamine, triethylamine, N,N-dimethylaniline, triethylenediamine and 2,4,6-tris(dimethylaminomethyl)phenol, quaternary ammonium salts such as trimethylbenzyl ammonium chloride, and metal salts such as lithium chloride.

In addition to vinyl ester resins comprising the epoxy (meth)acrylates mentioned above, resins obtained by reacting at least one type selected from among a saturated dicarboxylic acid and an unsaturated dicarboxylic acid with a saturated polyester resin or unsaturated polyester having a terminal carboxyl group obtained from a polyhydric alcohol and polyester (meth)acrylates of saturated polyester resins and unsaturated polyester resins obtained by reacting bisphenol compounds such as bisphenol A, bisphenol AD, bisphenol F or bisphenol S with an epoxy group-containing α,β-unsaturated monocarboxylic acid derivative can be used as the vinyl ester resin.

Examples of bisphenol compounds include bisphenol A, bisphenol AD, bisphenol F, bisphenol S, bisphenol novolac and cresol novolac. Examples of epoxy group-containing α,β-unsaturated monocarboxylic acid derivatives include glycidyl acrylate and glycidyl methacrylate. In addition, compounds similar to those listed as raw material components of the unsaturated polyester mentioned above can be used as the saturated dicarboxylic acid, unsaturated dicarboxylic acid and polyhydric alcohol.

### (B) Polymerizable unsaturated compound

In the resin composition for sealing an electronic control device of this invention, the thermosetting resin (A) and polymerizable unsaturated compound (B) may be blended separately, but it is preferable to dissolve the thermosetting resin (A) in the polymerizable unsaturated compound (B) and use the obtained solution.

The polymerizable unsaturated compound (B) is not particularly limited as long as the compound has a polymerizable double bond that can be copolymerized with the unsaturated polyester resin and the vinyl ester resin. Examples of the polymerizable unsaturated compound (B) include aromatic monomers such as styrene, vinyltoluene and vinylbenzene, acrylic monomers such as methyl (meth)acrylate, triallylisocyanurate ethylene glycol di(meth)acrylate, diethylene glycol di(meth)acrylate, tetraethylene glycol di(meth)acrylate, 1,4-butane diol di(meth)acrylate, 1,6-hexane diol di(meth)acrylate, 1,9-nonane diol di(meth)acrylate, trimethylolpropane tri(meth)acrylate, glycerin di(meth)acrylate, 2-hydroxy-3-acryloyloxypropyl (meth)acrylate, ethylene glycol dimethacrylate, triethylene glycol di(meth)acrylate, polyethylene glycol di(meth)acrylate, tripropylene glycol di(meth)acrylate, neopentyl glycol di(meth)acrylate, 1,3-butane diol di(meth)acrylate, 1,10-decane diol di(meth)acrylate and 2-hydroxyethyl (meth)acrylate, diallyl phthalate and diallyl phthalate prepolymers. It is possible to use one of these polymerizable unsaturated compounds, or two or more types thereof.

The content of the polymerizable unsaturated compound (B) in this invention is preferably 20 to 90 mass%, more preferably 30 to 75 mass%, and most preferably 40 to 70 mass%, relative to the total amount of the thermosetting resin (A) and the polymerizable unsaturated compound (B). If the content of the polymerizable unsaturated compound (B) falls within the range mentioned above, workability and moldability during molding are good and the characteristics of a cured product can be adequately brought out.

### (C) Inorganic filler

The inorganic filler (C) used in this invention has the function of adjusting the viscosity of the resin composition so as to be suitable for handling and improving the moldability of the resin composition. The inorganic filler (C) can be a publicly known inorganic filler, and examples thereof include calcium carbonate, calcium sulfate, barium sulfate, talc, kaolin, aluminum hydroxide, magnesium carbonate, aluminum oxide, magnesium oxide, beryllium oxide, aluminum nitride, boron nitride, titanium nitride, silicon carbide, boron carbide, titanium carbide and titanium boride. It is possible to use one of these inorganic fillers, or two or more types thereof. Of these, it is preferable to use at least one type selected from among calcium carbonate, aluminum hydroxide and aluminum oxide from the perspectives of kneadability, moldability and cost of the resin composition.

The average primary particle diameter (average particle diameter of primary particles) of the inorganic filler (C) is preferably 0.5 to 30 µm, and more preferably 1 to 20 µm, from the perspective of homogeneously dispersing the inorganic filler in the resin composition for sealing an electronic control device. In addition, the form of the inorganic filler (C) is preferably an amorphous or spherical powder. If the inorganic filler is an amorphous or spherical powder, it is possible to effectively lower the viscosity of the resin composition when a sealing material is formed and effectively prevent unfilled portions from occurring in a cured product. Moreover, in this specification, the average particle diameter is the volume-based median diameter (d50) measured using a laser diffraction/scattering type particle size distribution measurement apparatus (FRA available from MicrotracBEL Corp.). If the average primary particle diameter of the inorganic filler is 0.5 to 30 µm, it is possible to obtain a resin composition having a suitable viscosity.

The content of the inorganic filler (C) in this invention is 150 to 700 parts by mass, preferably 250 to 650 parts by mass, and more preferably 300 to 600 parts by mass, relative to a total of 100 parts by mass of the thermosetting resin (A) and the polymerizable unsaturated compound (B). If the content of the inorganic filler (C) is 150 to 700 parts by mass, the surface smoothness and mechanical strength of a cured product are good and the resin composition has a suitable fluidity and excellent moldability.

### (D) Glass fibers

Publicly known glass fibers can be used as the glass fibers (D) used in this invention. The fiber length of the glass fibers (D) is preferably 0.01 to 13 mm, more preferably 0.01 to 6 mm, and most preferably 0.01 to 3 mm. If the fiber length of the glass fibers (D) is 0.01 to 13 mm, the fluidity of the resin composition for sealing an electronic control device in a mold is improved. The fiber diameter of the glass fibers (D) is preferably 5 to 20 µm, more preferably 8 to 17 µm, and most preferably 10 to 15 µm. If the fiber diameter of the glass fibers (D) is 5 to 20 µm, the fluidity of the resin composition for sealing an electronic control device in a mold is improved.

The content of the glass fibers (D) in this invention is 0.1 to 60 parts by mass, preferably 3 to 50 parts by mass, and more preferably 3 to 40 parts by mass, relative to a total of 100 parts by mass of the thermosetting resin (A) and the polymerizable unsaturated compound (B). If the content of the glass fibers (D) is 0.1 to 60 parts by mass, the mechanical strength of a cured product is good and the resin composition has a suitable fluidity and excellent moldability.

### (E) Internal mold release agent

A publicly known internal mold release agent can be used as the internal mold release agent (E) used in this invention. Examples of the internal mold release agent (E) include stearic acid, stearic acid salts such as zinc stearate, calcium stearate, aluminum stearate and magnesium stearate, an internal mold release agent comprising a surfactant and a copolymer, to which a filler is adsorbed at the time of molding (product name: BYK-P 9050, available from BYK Japan KK) and carnauba wax. It is possible to use one of these internal mold release agents, or two or more types thereof. Of these, zinc stearate is preferred.

The content of the internal mold release agent (E) in this invention is preferably 1 to 15 parts by mass, more preferably 2 to 13 parts by mass, and most preferably 3 to 10 parts by mass, relative to a total of 100 parts by mass of the thermosetting resin (A) and the polymerizable unsaturated compound (B). If the content of the internal mold release agent (E) is 1 to 15 parts by mass, a cured product can be easily released from a molding die.

### (F) Coupling agent

Examples of the coupling agent (F) used in this invention include silane coupling agents having an alkoxy group and a functional group such as a (meth)acryloyloxy group, an epoxy group, a vinyl group, an amino group, an acid anhydride group, an isocyanate group or an alkyl group. Examples of the silane coupling agent include vinylmethoxysilane, vinylethoxysilane, vinyltris(2-methoxyethoxy)silane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, tris-(trimethoxysilylpropyl) isocyanurate, 3-ureidopropyltrialkoxysilane, 3-mercaptopropylmethyldimethoxysilane, 3-mercaptopropyltrimethoxysilane and 3-isocyanatopropyltriethoxysilane. It is possible to use one of these silane coupling agents, or two or more types thereof. Of these, a silane compound having a (meth)acryloyloxy group and an alkoxy group is preferred and 3-methacryloxypropyltrimethoxysilane is more preferred from the perspectives of adhesive properties and cost.

The content of the coupling agent (F) in this invention is 1.4 to 20 parts by mass, preferably 3.0 to 15 parts by mass, and more preferably 3.0 to 10 parts by mass, relative to a total of 100 parts by mass of the thermosetting resin (A) and the polymerizable unsaturated compound (B). If the content of the coupling agent (F) is 1.4 to 20 parts by mass, sufficient adhesive properties can be achieved even in electric control device applications.

### (G) Curing agent

The curing agent (G) used in this invention is not particularly limited, but examples thereof include organic peroxides that are publicly known in the technical field of this invention. Examples of such organic peroxides include t-butylperoxy-2-ethylhexanoate, t-hexylperoxy-2-ethylhexanoate, 1,1,3,3-tetramethylbutylperoxy-2-ethylhexanoate, benzoyl peroxide, 1,1-di-t-butylperoxycyclohexane, 1,1-di-t-hexylperoxycyclohexane, 1,1-di-t-butylperoxy-3,3,5-trimethylcyclohexane, t-butylperoxyisopropyl carbonate, t-hexylperoxyisopropyl carbonate, t-butyl peroxybenzoate, t-hexyl peroxybenzoate, 1,6-bis(t-butylperoxycarbonyloxy)hexane, dicumyl peroxide and di-t-butyl peroxide. It is possible to use one of these curing agents, or two or more types thereof.

The content of the curing agent (G) in this invention is preferably 0.1 to 15 parts by mass, more preferably 1 to 10 parts by mass, and further preferably 2 to 8 parts by mass, relative to a total of 100 parts by mass of the thermosetting resin (A) and the polymerizable unsaturated compound (B). If the content of the curing agent (G) is 0.1 parts by mass or more, the resin composition for sealing an electronic control device can be sufficiently cured. If the content of the curing agent (G) is 15 parts by mass or less, storage stability of the resin composition for sealing an electronic control device is improved.

From the perspective of improving various physical properties, the resin composition for sealing an electronic control device of this invention can, if necessary, contain optional components such as a low shrinkage agent (H), a thickening agent (I) and a pigment (J).

### (H) Low shrinkage agent

The low shrinkage agent (H) used in this invention is not particularly limited, but examples thereof include thermoplastic polymers that are publicly known in the technical field of this invention. Examples of such thermoplastic polymers include polystyrene, poly(methyl methacrylate), poly(vinyl acetate), saturated polyesters and styrene-butadiene-based rubbers. It is possible to use one of these low shrinkage agents, or two or more types thereof. Of these, polystyrene is preferred from the perspective of reducing shrinkage.

### (I) Thickening agent

The thickening agent (I) used in this invention is not particularly limited, but examples thereof include metal oxides such as magnesium oxide, magnesium hydroxide, calcium hydroxide and calcium oxide, and isocyanate compounds. It is possible to use one of these thickening agents, or two or more types thereof.

### (J) Pigment

The pigment (J) used in this invention is not particularly limited, but examples thereof include yellow pigments such as C.I. Pigment Yellow 1, 3, 12, 13, 14, 15, 16, 17, 20, 24, 31, 53, 83, 86, 93, 94, 109, 110, 117, 125, 128, 137, 138, 139, 147, 148, 150, 153, 154, 166, 173, 194 and 214; orange pigments such as C.I. Pigment Orange 13, 31, 36, 38, 40, 42, 43, 51, 55, 59, 61, 64, 65, 71 and 73; red pigments such as C.I. Pigment Red 9, 97, 105, 122, 123, 144, 149, 166, 168, 176, 177, 180, 192, 209, 215, 216, 224, 242, 254, 255, 264 and 265; blue pigments such as C.I. Pigment Blue 15, 15:3, 15:4, 15:6 and 60; violet pigments such as C.I. Pigment Violet 1, 19, 23, 29, 32, 36 and 38; green pigments such as C.I. Pigment Green 7, 36 and 58; brown pigments such as C.I. Pigment Brown 23 and 25; and black pigments such as C.I. Pigment Black 1 and 7, carbon black, titanium black and iron oxide. It is possible to use one of these pigments, or two or more types thereof.

Moreover, the content values of the low shrinkage agent (H), thickening agent (I) and pigment (J) are not particularly limited as long as the advantageous effect of this invention is not impaired.

The resin composition for sealing an electronic control device of this invention can be produced by, for example, mixing components (A) to (G) and optional components if required. The mixing method is not particularly limited, and it is possible to use, for example, a double arm kneader, a pressurization type kneader or a planetary mixer. The mixing temperature is preferably 20°C to 50°C, and more preferably 30°C to 50°C. A mixing temperature of 20°C or higher is preferred from the perspective of ease of mixing. A mixing temperature of 50°C or lower is preferred from the perspective of suppressing polymerization reactions of the resin composition.

When the resin composition for sealing an electronic control device of this invention is produced, the order in which the components are kneaded is not particularly limited. For example, from the perspective of readily obtaining a resin composition having a uniform compositional makeup, it is preferable to mix some or all of the thermosetting resin (A) and the polymerizable unsaturated compound (B) and then mix the other components.

### [Electronic control device]

In the electronic control device of this invention, a cured product of the resin composition for sealing an electronic control device is filled in a space between a metal housing and a substrate. The method for filling and curing the resin composition for sealing an electronic control device in the space between a metal housing and a substrate is not particularly limited, but transfer molding or injection molding is preferred. Molding conditions vary according to the type of curing agent (organic peroxide) being used, but a temperature of 130°C to 160°C, a pressure of 4 to 20 MPa and a rate of 1 to 8 min/mm can be used.

### Examples

This invention will now be explained in greater detail through the use of examples and comparative examples. (Components used)

Components shown in Table 1 were used.

### [Table 1]

**Table 1**

| | Type | Product name | Manufacturer |
|---|---|---|---|
| (A) Thermosetting resin + (B) polymerizable unsaturated compound | Unsaturated polyester resin (containing 27% of styrene monomer) | Rigolac M-500D | Showa Denko K. K. |
| | Vinyl ester resin (containing 30% of styrene monomer) | Ripoxy R-802 | Showa Denko K. K. |
| (C) Inorganic filler | Calcium carbonate (d50: 4 µm, dmax: 45 µm) | KS-1000 | Calfine Co., Ltd. |
| | Aluminum hydroxide (d50: 4 µm, dmax: 75 µm) | Higilite H-34 | Showa Denko K. K. |
| | Aluminum hydroxide (d50: 4 µm, dmax: 45 µm) | CL-303 | Sumitomo Chemical Co., Ltd. |
| | Aluminum oxide (d50: 1 µm, dmax: 25 µm) | Alumina AL-47-1 | Showa Denko K. K. |
| | Spherical silica (d50: 20 µm, dmax: 75 µm) | MSR-7000 | Tatsumori |
| (D) Glass fibers | Fiber length: 3 mm | CS3PE907S | Nitto Boseki Co., Ltd. |
| | Fiber length: 9 mm | CS9PE907S | Nitto Boseki Co., Ltd. |
| (E) Internal mold release agent | Zinc stearate | Zinc Stearate | NOF Corporation |
| | Carnauba wax (melting point: 83°C) | Nikko Carnauba | Nikko Fi ne |
| (F) Coupling agent | 3-methacryloxypropyltrimethoxysilane | KBM-503 | Shin-Etsu Chemical Co., Ltd. |
| | 3-glycidoxypropyltriethoxysilane | KBE-403 | Shin-Etsu Chemical Co., Ltd. |
| (G) Curing agent | t-butyl peroxide | Perbutyl Z | NOF Corporation |
| (H) Low shrinkage material | Polystyrene (containing 60% of styrene monomer) | Rigolac M-5585 | Showa Denko K. K. |
| | Silicone resin | KMP-594 | Shin-Etsu Chemical Co., Ltd. |
| Others | Cresol novolac type epoxy resin | EOCN-1020-55 | Nippon Kayaku Co., Ltd. |
| | Epoxy curing agent (phenol resin) | PR-HF-3 | Sumitomo Bakelite Co., Ltd. |
| | Triphenylphosphine | TPP | Hokko Chemical Industry Co., Ltd. |

### (Preparation of resin composition)

In accordance with the blending components and blending quantities shown in Tables 2 to 4, resin compositions of Examples 1 to 12 and Comparative Examples 1 to 7 were prepared by kneading for 30 minutes at 25°C using a double arm kneader. Moreover, the units for the blending quantities of the blending components in Tables 2 to 4 are parts by mass. The styrene shown in Table 2 includes styrene monomer contained in component (A) and the like in Table 1.

### [Table 2]

**Table 2**

| | | | Example 1 | Example 2 | Example 3 | Example 4 | Example 5 | Example 6 |
|---|---|---|---|---|---|---|---|---|
| Formulation | (A) Thermosetting resin | Unsaturated polyester resin | 73 | 73 | 73 | 73 | 73 | 73 |
| | | Vinyl ester resin | | | | | | |
| | (B) Polymerizable unsaturated compound | Styrene | 63 | 63 | 63 | 63 | 63 | 63 |
| | (C) Inorganic filler | Calcium carbonate | 600 | 600 | 300 | 300 | 300 | 600 |
| | | Aluminum hydroxide Higilite H-34 | | | 270 | | | |
| | | Alumina | | | | 440 | 440 | |
| | | Spherical silica | | | | | | |
| | (D) Glass fibers | Fiber length: 3 mm | 40 | 40 | 40 | 40 | | 40 |
| | | Fiber length: 9 mm | | | | | 40 | |
| | (E) Internal mold release agent | Zinc stearate | 8 | 13 | 8 | 8 | 8 | 3 |
| | (F) Coupling agent | 3-methacryloxypropyltrimethoxysilane | 7 | 7 | 7 | 7 | 7 | 7 |
| | | 3-glycidoxypropyltriethoxysilane | | | | | | |
| | (G) Curing agent | t-butyl peroxide | 3 | 3 | 3 | 3 | 3 | 3 |
| | (H) Low shrinkage material | Polystyrene | 24 | 24 | 24 | 24 | 24 | 24 |
| Compositional ratios | C/(A+B) × 100 | | 441 | 441 | 419 | 544 | 544 | 441 |
| | D/(A+B) × 100 | | 29 | 29 | 29 | 29 | 29 | 29 |
| | F/(A+B) × 100 | | 5.1 | 5.1 | 5.1 | 5.1 | 5.1 | 5.1 |

### [Table 3]

**Table 3**

| | | | Example 7 | Example 8 | Example 9 | Example 10 | Example 11 | Example 12 |
|---|---|---|---|---|---|---|---|---|
| | (A) Thermosetting resin | Unsaturated polyester resin | 73 | 73 | 73 | 73 | 36.5 | 73 |
| | | Vinyl ester resin | | | | | 35 | |
| | (B) Polymerizable unsaturated compound | Styrene | 51 | 63 | 63 | 63 | 64.5 | 63 |
| | (C) Inorganic filler | Calcium carbonate | 200 | 800 | 600 | 600 | 600 | 600 |
| | | Aluminum hydroxide Higilite H-34 | | | | | | |
| | | Alumina | | | | | | |
| | | Spherical silica | | | | | | |
| Formulation | (D) Glass fibers | Fiber length: 3 mm | 40 | 40 | | 60 | 40 | 40 |
| | | Fiber length: 9 mm | | | 5 | | | |
| | (E) Internal mold release agent | Zinc stearate | 8 | 8 | 8 | 8 | 8 | 8 |
| | (F) Coupling agent | 3-methacryloxypropyltrimethoxysilane | 7 | 7 | 7 | 7 | 7 | 2 |
| | | 3-glycidoxypropyltriethoxysilane | | | | | | |
| | (G) Curing agent | t-butyl peroxide | 3 | 3 | 3 | 3 | 3 | 3 |
| | (H) Low shrinkage material | Polystyrene | 16 | 24 | 24 | 24 | 24 | 24 |
| Compositional ratios | C/(A+B) × 100 | | 161 | 588 | 441 | 441 | 441 | 441 |
| | D/(A+B) × 100 | | 32 | 29 | 3.7 | 44 | 29 | 29 |
| | F/(A+B) × 100 | | 5.6 | 5.1 | 5.1 | 5.1 | 5.1 | 1.5 |

### [Table 4]

**Table 4**

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| | (A) Thermosetting resin | Unsaturated polyester resin | 94.9 | 73 | | 73 | 73 | 73 | 73 |
| | | Vinyl ester resin | | | | | | | |
| | (B) Polymerizable unsaturated compound | Styrene | 71.1 | 63 | | 63 | 63 | 63 | 63 |
| | (C) Inorganic filler | Calcium carbonate | 600 | 600 | | 1500 | 600 | 600 | 600 |
| | | Spherical silica | | | 75 | | | | |
| | | Aluminum hydroxide CL-303 | | | 5 | | | | |
| | (D) Glass fibers | Fiber length: 3 mm | | 40 | | 40 | 120 | 40 | 40 |
| | | Fiber length: 6 mm | | | | | | | |
| | (E) Internal mold release agent | Zinc stearate | 15 | 8 | | 8 | 8 | 8 | 8 |
| | | Carnauba wax | | | 0.3 | | | | |
| Formulation | (F) Coupling agent | 3-methacryloxypropyltrimethoxysilane | 7 | | | 7 | 7 | 0.5 | 1.3 |
| | | 3-glycidoxypropyltriethoxysilane | | | 0.2 | | | | |
| | (G) Curing agent | t-butyl peroxide | 3 | 3 | | 3 | 3 | 3 | 3 |
| | (H) Low shrinkage material | Polystyrene | 24 | 24 | | 24 | 24 | 24 | 24 |
| | Others | Epoxy resin | | | 11.8 | | | | |
| | | Low stress agent | | | 1 | | | | |
| | | Epoxy curing agent | | | 6 | | | | |
| | | Epoxy curing accelerator | | | 0.2 | | | | |
| Compositional ratios | C/(A+B) × 100 | | 361 | 441 | - | 1100 | 441 | 441 | 441 |
| | D/(A+B) × 100 | | 0 | 29 | - | 29 | 88 | 29 | 29 |
| | F/(A+B) × 100 | | 4.2 | 0 | - | 5.1 | 5.1 | 0.37 | 0.96 |

### (Evaluations)

The resin compositions of Examples 1 to 12 and Comparative Examples 1 to 7 were evaluated using the methods shown below. The evaluation results are shown in Tables 5 and 6.

### <Fluidity>

The flow length (spiral flow value) in a spiral flow test was used as an indicator of the fluidity of the thermosetting resin composition. In the spiral flow test, a spiral flow mold having a trapezoid flow path cross section (upper base a = 6 mm, lower base b = 8 mm, height h = 2 mm (all internal dimensions)), such as that shown in Fig. 1, was attached to a 70 ton transfer molding machine, and the spiral flow value was measured by carrying out a spiral flow test at a raw material charge quantity of 50 g, a molding temperature of 140°C and a molding pressure of 5 MPa. A higher spiral flow value indicates higher fluidity. If the spiral flow value is 60 cm or more, fluidity as a material for sealing an electronic control device is good.

### <Adhesive properties>

An aluminum foil measuring 7 cm on each side (and having a thickness of 20 µm) was placed in a mold capable of molding to a diameter ϕ of 117 mm and a thickness of 3 mm, and a transfer-molded body (having a diameter ϕ of 117 mm and a thickness of 3 mm) was produced by transfer molding at a molding temperature of 140°C, an injection pressure of 10 MPa and a molding time of 2 minutes. The aluminum foil tightly adhered to the molded body was cut to a width of 1 cm, a load was applied by hanging a weight, and the load required to completely separate the aluminum foil from the molded body was measured. A higher load value means higher adhesive properties. If the load is 100 g/cm or more, adhesive properties as a material for sealing an electronic control device are good.

### <Coefficient of linear expansion>

A flat board measuring 90 mm × 10 mm and having a thickness of 4 mm was formed by compression molding at a molding temperature of 140°C, a molding pressure of 10 MPa and a molding time of 3 minutes, a test piece measuring 20 mm × 4 mm × 4 mm was cut from the flat board, and the coefficient of linear expansion was measured using a TMA method (using a TMA8310 available from Rigaku Corporation). The temperature increase rate was 3°C/min, and the measurement temperature range was 40°C to 150°C. If the coefficient of linear expansion is 20 ppm/°C or less, heat resistance as a resin composition for sealing an electronic control device is good.

### <Release properties>

A shrinkage disk specified in JIS K-6911 5.7 was prepared by injection molding using a mold capable of molding the shrinkage disk at a transfer molding temperature of 140°C, a molding pressure of 10 MPa and a molding time of 2 minutes, and the presence or absence of release defects such as material remaining in the cavity or core part was visually confirmed after continuously carrying out 100 molding shots. Cases where release defects did not occur were evaluated as O, and cases where release defects did occur were evaluated as X.

### [Table 5]

**Table 5**

| | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|
| Evaluation results | Fluidity (cm) | 95 | 90 | 100 | 110 | 85 | 100 | 135 | 75 | 115 | 75 | 93 | 92 |
| | Adhesive properties (g/cm) | 150 | 130 | 160 | 170 | 170 | 250 | 180 | 140 | 160 | 160 | 180 | 110 |
| | Coefficient of linear expansion (ppm/°C) | 18 | 19 | 18 | 18 | 17 | 17 | 20 | 15 | 20 | 14 | 18 | 18 |
| | Release properties | ○ | ○ | ○ | ○ | ○ | ○ | ○ | ○ | ○ | ○ | ○ | ○ |

### [Table 6]

**Table 6**

| | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| Evaluation results | Fluidity (cm) | 130 | 80 | - | Failed in mixing Not measurable | 30 | 84 | 86 |
| | Adhesive properties (g/cm) | 179 | 50 | Not cured Not measurable | | 160 | 70 | 85 |
| | Coefficient of linear expansion (ppm/°C) | 24 | 16 | | | 13 | 18 | 18 |
| | Release properties | ○ | ○ | | | ○ | ○ | ○ |

As shown in Table 5, it was confirmed that the resin compositions of Examples 1 to 12 could be molded at a molding temperature of 140°C and exhibited good fluidity, adhesive properties and coefficient of linear expansion.

Moreover, this international application claims priority on the basis of Japanese Patent Application No. 2017-083588, which was filed on 20 April 2017, and the entire contents of that application are incorporated herein by reference.

## Claims

1. A resin composition for sealing an electronic control device, the resin composition comprising:
(A) at least one type of thermosetting resin selected from among an unsaturated polyester resin and a vinyl ester resin,
(B) a polymerizable unsaturated compound,
(C) an inorganic filler,
(D) glass fibers,
(E) an internal mold release agent,
(F) a coupling agent, and
(G) a curing agent,
wherein, relative to a total of 100 parts by mass of the thermosetting resin (A) and the polymerizable unsaturated compound (B), the content of the inorganic filler (C) is 150 to 700 parts by mass, the content of the glass fibers (D) is 0.1 to 60 parts by mass, and the content of the coupling agent (F) is 1.4 to 20 parts by mass.

2. The resin composition for sealing an electronic control device according to claim 1, wherein the content of the coupling agent (F) is 3.0 to 15 parts by mass relative to a total of 100 parts by mass of the thermosetting resin (A) and the polymerizable unsaturated compound (B).

3. The resin composition for sealing an electronic control device according to claim 1 or claim 2, wherein the inorganic filler (C) is a powder and has an average primary particle diameter of 0.5 to 30 µm.

4. The resin composition for sealing an electronic control device according to any one of claims 1 to 3, wherein the inorganic filler (C) is at least one type selected from among calcium carbonate, aluminum hydroxide and aluminum oxide.

5. The resin composition for sealing an electronic control device according to any one of claims 1 to 4, wherein the fiber length of the glass fibers (D) is 0.01 mm to 13 mm.

6. The resin composition for sealing an electronic control device according to any one of claims 1 to 5, wherein the content of the internal mold release agent (E) is 3 to 15 parts by mass relative to a total of 100 parts by mass of the thermosetting resin (A) and the polymerizable unsaturated compound (B).

7. The resin composition for sealing an electronic control device according to any one of claims 1 to 6, wherein the thermosetting resin (A) is an unsaturated polyester resin.

8. An electronic control device, wherein a space between a metal housing and a substrate is filled with a cured product of a resin composition, the resin composition comprising:
(A) at least one type of thermosetting resin selected from among an unsaturated polyester resin and a vinyl ester resin,
(B) a polymerizable unsaturated compound,
(C) an inorganic filler,
(D) glass fibers,
(E) an internal mold release agent,
(F) a coupling agent, and
(G) a curing agent,
wherein, relative to a total of 100 parts by mass of the thermosetting resin (A) and the polymerizable unsaturated compound (B), the content of the inorganic filler (C) is 150 to 700 parts by mass, the content of the glass fibers (D) is 0.1 to 60 parts by mass, and the content of the coupling agent (F) is 1.4 to 20 parts by mass.

9. A method for producing an electronic control device, the method comprising filling a space between a metal housing and a substrate with a resin composition, and curing the composition, the resin composition comprising:
(A) at least one type of thermosetting resin selected from among an unsaturated polyester resin and a vinyl ester resin,
(B) a polymerizable unsaturated compound,
(C) an inorganic filler,
(D) glass fibers,
(E) an internal mold release agent,
(F) a coupling agent, and
(G) a curing agent,
wherein, relative to a total of 100 parts by mass of the thermosetting resin (A) and the polymerizable unsaturated compound (B), the content of the inorganic filler (C) is 150 to 700 parts by mass, the content of the glass fibers (D) is 0.1 to 60 parts by mass, and the content of the coupling agent (F) is 1.4 to 20 parts by mass.

10. The method for producing an electronic control device according to claim 9, wherein the resin composition is filled and cured by means of transfer molding or injection molding.
